# EUROPEAN PATENT APPLICATION

(11) **EP 4 719 036 A1**
(43) Date of publication of application: **01.04.2026**
(21) Application number: 25205111.5
(22) Date of filing: 26.09.2025
(51) Int. Cl.: H10W 70/40, H10W 90/00

(54) **SEMICONDUCTOR DEVICE AS WELL AS A METHOD OF MANUFACTURING SUCH SEMICONDUCTOR DEVICE**

(30) Priority: 27.09.2024 NL 2038727
(71) Applicant: Nexperia B.V., 6534 AB Nijmegen (NL)
(72) Inventor: Yandoc, Ricardo Lagmay, Manchester (GB); Lawson, Wayne, Manchester (GB); Fang, Zhou, Shanghai (CN)
(74) Representative: Pjanovic, Ilija

(57) **Abstract**

The present disclosure proposes a semiconductor device as well as a method for manufacturing such semiconductor device related to a method of generating a dual exposed drain with common gate and source clip-bonded package for reverse battery protection. The semiconductor device comprises a first lead frame with an external first lead frame terminal and a first die paddle, a second lead frame with an external second lead frame terminal and a second die paddle, a common clip with an external source clip terminal, a two source contacts, a common gate clip with an external common clip gate terminal, a clip contact and a gate clip contact, a first semiconductor die with a first die gate terminal, a first die source terminal, and a first die drain terminal, a second semiconductor die with a second die gate terminal, a second die source terminal, and a second die drain terminal.

## Description

### TECHNICAL FIELD

The present disclosure relates to the field of semiconductor devices as well as a method for manufacturing semiconductor devices related to a method of generating a dual exposed drain with common gate and source clip-bonded package for reverse battery protection.

### BACKGROUND OF THE DISCLOSURE

The disclosure is related to a method of generating a dual exposed drain with common gate and source for reverse battery protection and isolation switch or similar. In the prior art, there is a known solution that uses wires in forming the circuit for manufacturing semiconductor device for reverse battery protection. The new disclosure uses a clip bonding process to increase efficiency and reduce source and gate resistance, so that the device can perform better.

Another known solution uses a clip bonding technique in order to make a device with common source and gate, but the production of the device in the prior art is complicated and consists of many stages. The disclosure allows to facilitate the production process of the semiconductor device and the size of the device can be reduced.

The goal of the disclosure is to provide a package which is more efficient and manufacturable and where a source and gate resistance will spread equally. Known solutions do not provide answers to all abovementioned problems.

### SUMMARY OF THE DISCLOSURE

A first example of the disclosure is a semiconductor device. The semiconductor device comprises a first lead frame, a second lead frame, a common clip, a common gate clip, a first semiconductor die, a second semiconductor die and an encapsulation. The first lead frame comprises a first surface of the first lead frame and a second surface. The first surface of the first lead frame is directly opposite to the second surface of the first lead frame. The first lead frame comprises at least one external first lead frame terminal and a first die paddle. The second lead frame comprises a first surface of the second lead frame and a second surface. The first surface of the second lead frame is directly opposite to the second surface of the second lead frame. The second lead frame comprises at least one external second lead frame terminal and a second die paddle. The common clip comprises a first surface and a second surface, wherein the first surface is directly opposite to the second surface. The source clip comprises at least one external source clip terminal, a first source contact and a second source contact. The common gate clip comprises a first surface and a second surface, wherein the first surface is directly opposite to the second surface. The gate clip comprises an external common clip gate terminal, a clip contact and a gate clip contact. The first semiconductor die comprises a first surface of the first semiconductor die and a second surface. The first surface of the first semiconductor die is directly opposite to the second surface of the first semiconductor die. The first semiconductor die comprises a first die gate terminal, a first die source terminal and a first die drain terminal. The first die gate terminal, and the first die source terminal are located on the second surface of the first semiconductor die, and the first die drain terminal is located on the first surface of the first semiconductor die. The second semiconductor die comprises a first surface of the second semiconductor die and a second surface. The first surface of the second semiconductor die is directly opposite to the second surface of the second semiconductor die. The second semiconductor die comprises a second die gate terminal, a second die source terminal and a second die drain terminal. The second die gate terminal, and the second die source terminal are located on the second surface of the second semiconductor die, and the second die drain terminal is located on the first surface of the second semiconductor die. The first die gate terminal is connected by connecting means with the first surface of the clip contact, and the second die gate terminal is connected by connecting means with the first surface of the gate clip contact. The first die source terminal is connected by connecting means with the first surface of the first source contact, and the second die source terminal is connected by connecting means with the first surface of the second source contact. The first drain terminal is connected by connecting means with the second surface of the first die paddle contact area, and the second drain terminal is connected by connecting means with the second surface of the second die paddle contact area. The encapsulation encapsulates the first die, the second die, the first lead frame, the second lead frame, the common clip and the common gate clip, such that the at least one external first lead frame terminal, the at least one external second lead frame terminal, the first surface of the first die paddle contact area and the first surface of the second die paddle contact area, the external common clip gate terminal, the at least one external source clip terminal, and preferably the first surface of the common clip, are exposed.

Preferably, the at least one external first lead frame terminal and the at least one external second lead frame terminal are curved, preferably in a gull wing formation.

Preferably, the connecting means are in a form of solder.

Preferably, the connecting means are in a form of connective adhesive.

Preferably, the clip contact and the gate clip contact are the most protruding parts toward the first surface in the common gate clip.

Preferably, the first source contact and the second source contact are the most protruding parts toward the first surface in the common clip.

A further example of the disclosure is a method of manufacturing a semiconductor device according to the disclosure. The method is composed of the steps of: dispensing connective means on the first die paddle contact area located on a second surface of the first lead frame and on the second die paddle contact area located on a second surface of the second lead frame, placing the first semiconductor die on the first lead frame such that the first surface of the first semiconductor die is in contact with the second surface of the first lead frame, and the second semiconductor die on the second lead frame such that the first surface of the second semiconductor die is in contact with the second surface of the second lead frame, dispensing connective means on the first die gate terminal, first die source terminal, second die gate terminal and second die source terminal, placing the common gate clip and the common clip to the first die and to the second die, connecting by reflowing or baking, encapsulating the first die, the second die, the first lead frame, the second lead frame, the common clip and the common gate clip, with mold compound, immersing the individual clip or electroplating the assembled semiconductor devices, trimming and forming the semiconductor device such that the at least one external first lead frame terminal, the at least one external second lead frame terminal, the first surface of the first die paddle contact area and the first surface of the second die paddle contact area, the external common clip gate terminal, the at least one external source clip terminal, and preferably the external source clip terminal, are exposed, singulating the semiconductor device.

Preferably, the common gate clip and common clip mounting clip is individually and/or matrix mounted.

Preferably, after step f) there is an additional step f') of package polishing.

Preferably, the connective means used in steps a) and b) are in a form of conductive adhesive or a solder.

### BRIEF DESCRIPTION OF THE DRAWINGS

The disclosure will now be discussed with reference to the drawings, which show in:
Figure 1 a top view of the semiconductor device,
Figure 2 a bottom view of the semiconductor device,
Figure 3 a side view of the semiconductor device,
Figure 4 a side view from another perspective of the semiconductor device,
Figure 5 an isometric view of the bottom view of the semiconductor device,
Figure 6 an isometric view of the top view of the semiconductor device,
Figure 7 an exploded view of the interior of the semiconductor device,
Figure 8 a bottom view of the alternative external clip source terminal design,
Figure 9 an isometric view of the bottom view of the alternative external clip source terminal design.

### DETAILED DESCRIPTION OF THE DISCLOSURE

For a proper understanding of the disclosure, in the detailed description below corresponding elements or parts of the disclosure will be denoted with identical reference numerals in the drawings.

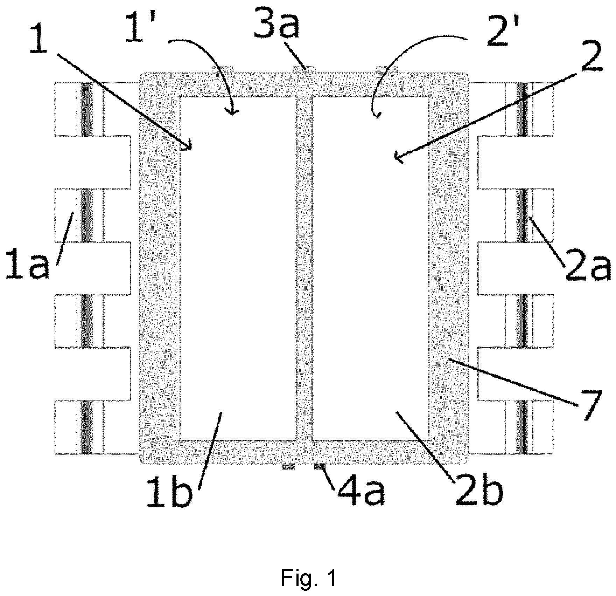

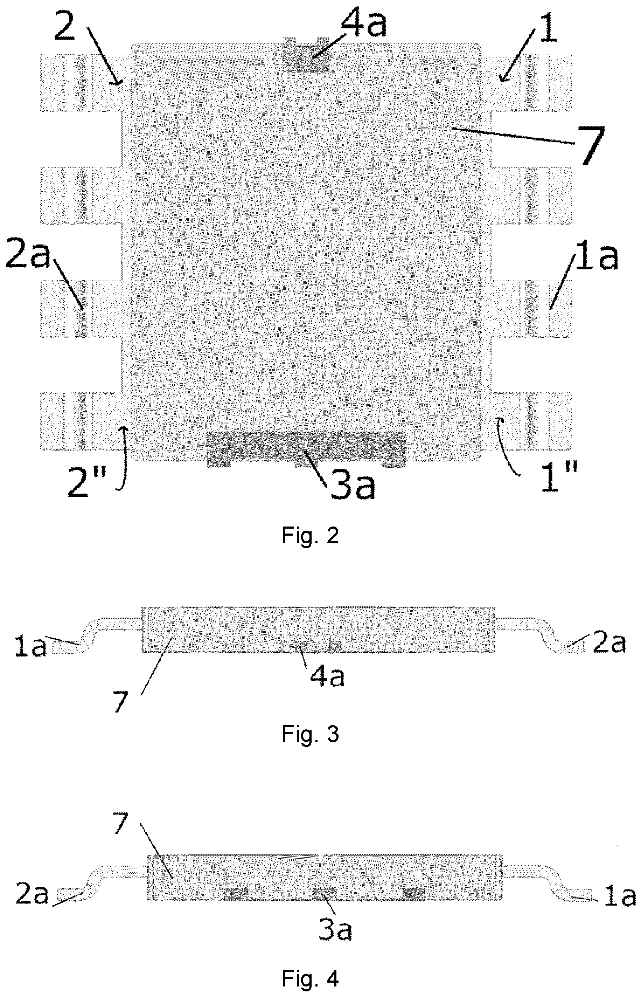

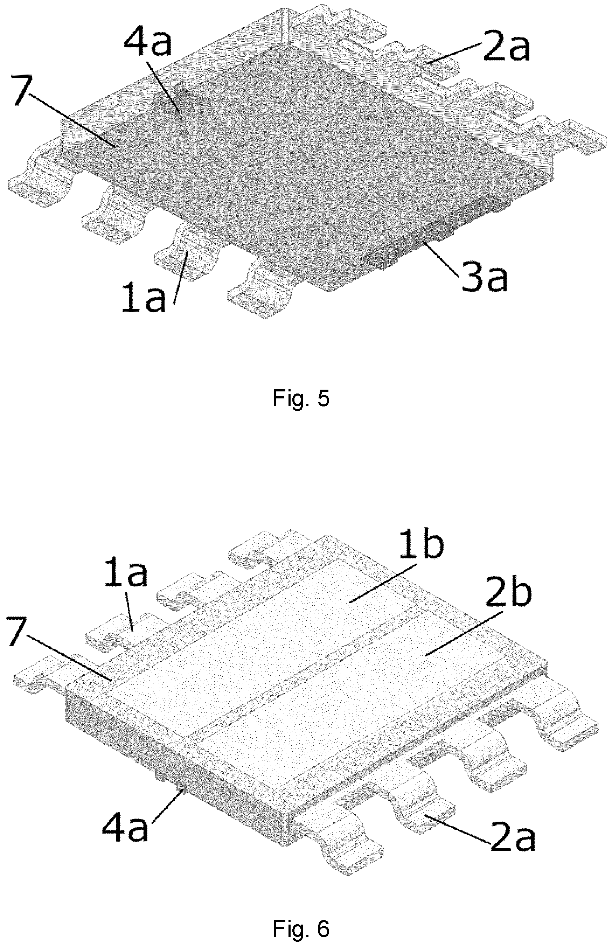

The semiconductor device comprises a first lead frame 1, a second lead frame 2, a common clip 3, a common gate clip 4, a first semiconductor die 5, a second semiconductor die 6 and an encapsulation 7. The semiconductor device is shown in fig. 1-4 and the internal structure of the semiconductor device is shown in fig. 5.

The first lead frame 1 comprises a first surface 1' of the first lead frame 1 and a second surface 1", wherein the first surface 1' of the first lead frame 1 is directly opposite to the second surface 1" of the first lead frame 1. The first lead frame 1 also comprises at least one external first lead frame terminal 1a and a first die paddle 1b.

The second lead frame 2 comprises a first surface 2' of the second lead frame 2 and a second surface 2", wherein the first surface 2' of the second lead frame 2 is directly opposite to the second surface 2" of the second lead frame 2. The second lead frame 2 also comprises at least one external second lead frame terminal 2a and a second die paddle 2b.

The common clip 3 comprises a first surface 3' and a second surface 3", wherein the first surface 3' is directly opposite to the second surface 3". The common clip also comprises at least one external source clip terminal 3a, a first source contact 3c and a second source contact 3d. In this example the first source contact 3c and the second source contact 3d are the most protruding parts toward the first surface 3' of the common clip 3, making it easier to connect them with the first and second die source terminals.

The common gate clip 4 comprises a first surface 4' and a second surface 4", wherein the first surface 4' is directly opposite to the second surface 4". The common gate clip 4 also comprises an external common clip gate terminal 4a, a clip contact 4b and a gate clip contact 4c. In this example the clip contact 4b and the gate clip contact 4c are the most protruding parts toward the first surface 4' of the common gate clip 4, making it easier to connect them with the first and second die gate terminals.

The external source clip terminal 3a and external common clip gate terminal 4a are meant to be directly connected, for example by soldering, to the PCB, wire or other components and they may be shaped as a micro leads in first example or they can be leadless in another example.

A first semiconductor die 5 comprises a first surface 5' of the first semiconductor die 5 and a second surface 5", wherein the first surface 5' of the first semiconductor die 5 is directly opposite to the second surface 5" of the first semiconductor die 5. The first semiconductor die 5 also comprises a first die gate terminal 5a, a first die source terminal 5b, and a first die drain terminal (not shown), wherein the first die gate terminal 5a, and the first die source terminal 5b are located on the second surface 5" of the first semiconductor die 5, and the first die drain terminal is located on the first surface 5' of the first semiconductor die 5.

The second semiconductor die 6 comprises a first surface 6' of the second semiconductor die 6 and a second surface 6", wherein the first surface 6' of the second semiconductor die 6 is directly opposite to the second surface 6" of the second semiconductor die 6. The second semiconductor die 6 also comprises a second die gate terminal (not shown), a second die source terminal 6b, and a second die drain terminal (not shown), wherein the second die gate terminal, and the second die source terminal 6b are located on the second surface 6" of the second semiconductor die 6, and the second die drain terminal is located on the first surface 6' of the second semiconductor die 6.

In this solution, the first semiconductor die 5 and the second semiconductor die 6 are placed next to each other (on the same level), which reduces the size of the semiconductor device and simplifies the assembly process.

In this example the first die gate terminal 5a is connected by soldering with the first surface 4' of the clip contact 4b, and the second die gate terminal is connected by soldering with the first surface 4' of the gate clip contact 4c using the clip-bonding technique. However, it should be noted that other means for mounting or connecting the first semiconductor die 5 and the second semiconductor die 6, as well as between other elements as mentioned in other parts of this description, with the common gate clip 4 may be used instead of a solder. For example, one of the mentioned connections may be achieved by using the conductive adhesive, while the other mounting connection is performed using a different technique using any other suitable die attach material.

In this example the first die source terminal 5b is connected by connecting means, such as a solder, with the first surface 3' of the first source contact 3c, and the second die source terminal 6b is connected by connecting means, such as a solder, with the first surface 3' of the second source contact 3d using the clip-bonding technique.

The clip-bonding technique used to connect the above-mentioned components of the semiconductor device facilitates the assembly process of the semiconductor device and reduces the number of its steps. With less resistance at the connections, the device performs better than the wire bonding known from prior art. Clip-bonding technique reduces the voltage loss through circuit and provides better thermal transfer than the wire bonding.

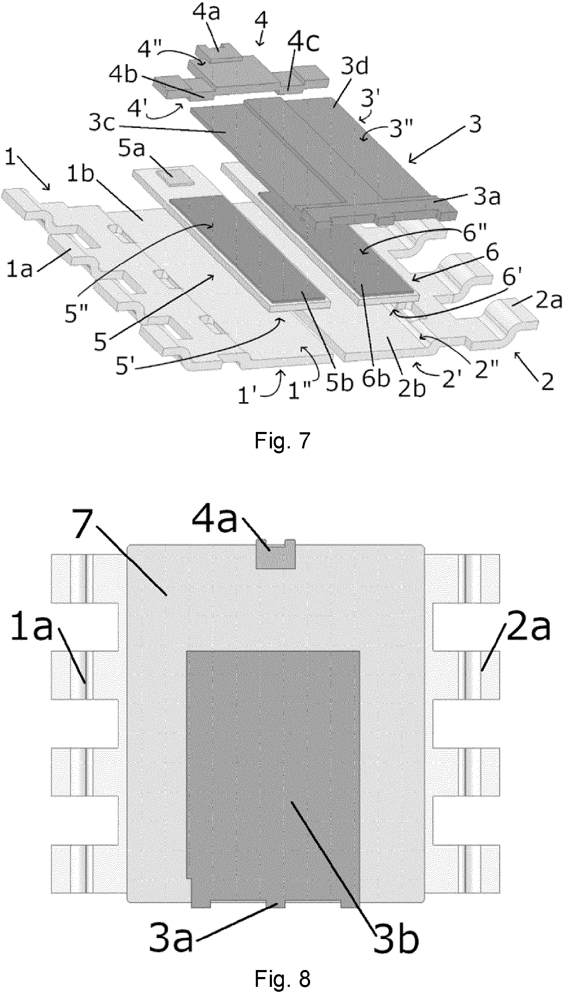

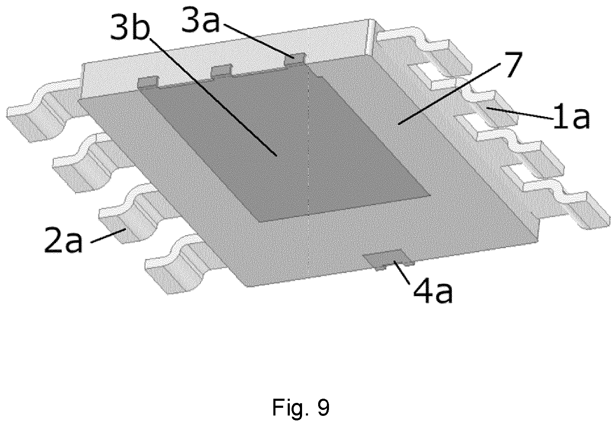

An encapsulation 7 encapsulates the first die 5, the second die 6, the first lead frame 1, the second lead frame 2, the common clip 3 and the common gate clip 4, such that the at least one external first lead frame terminal 1a, the at least one external second lead frame terminal 2a, the first surface 1' of the first die paddle 1b contact area and the first surface 2' of the second die paddle 2b contact area, the external common clip gate terminal 4a and the at least one external source clip terminal 3a are exposed. In another example shown in figs. 8 and 9, an external source clip flat terminal 3b, of the common clip 3 is exposed as well. The encapsulation is in a form of mold compound; however it should be noted that the encapsulation can be made by the use of a different method and material.

It should be noted that the external source clip flat terminal 3b is not shown in fig. 1-7 as it is an alternative way of manufacturing the common clip 3.

In another embodiment, the at least one external first lead frame terminal 1a and the at least one external second lead frame terminal 2a are shaped in a gull wing formation. The gull wing formation allows for easy connection of the at least one external first lead frame terminal 1a and the at least one external second lead frame terminal 2a with a PCB. However, it should be noted that the person skilled in the art will know that any other shape of the at least one external first lead frame terminal 1a and the at least one external second lead frame terminal 2a may be used.

A method of manufacturing a semiconductor device according to the disclosure is disclosed.

In a first step, step a, the connecting means are dispensed on the first die paddle 1b contact area located on a second surface 1" of the first lead frame 1 and on the second die paddle 2b contact area located on a second surface 2" of the second lead frame 2. In another example, the conductive adhesive may be dispensed on the first die paddle 1b contact area located on a second surface 1" of the first lead frame 1 and on the second die paddle 2b contact area located on a second surface 2" of the second lead frame 2.

In next step, step b, the first semiconductor die 5 is placed on the first lead frame 1 such that the first surface 5' of the first semiconductor die 5 is in contact with the second surface 1" of the first lead frame 1, and the second semiconductor die 6 is placed on the second lead frame 2 such that the first surface 6' of the second semiconductor die 6 is in contact with the second surface 2" of the second lead frame 2.

In next step, step c, the connecting means are dispensed on the first die gate terminal 5a, first die source terminal 5b, second die gate terminal 6a and second die gate terminal 6b. In another example, the conductive adhesive may be dispensed on the first die gate terminal 5a, first die source terminal 5b, second die gate terminal 6a and second die gate terminal 6b.

In the next step, step d, the common gate clip 4 and the common clip 3 is placed to the first die 5 and to the second die 6. In the first example, the common gate clip 4 and common clip 3 mounting clip are individually mounted. In another example, the common gate clip 4 and common clip 3 mounting clip are matrix mounted.

In the next step, step e, the connections are made by reflowing the solder. In another example, the connections are made by baking the conductive adhesive.

In the next step, step f, the first die 5, the second die 6, the first lead frame 1, the second lead frame 2, the common clip 3 and the common gate clip 4 are encapsulated with a mold compound. However, it should be noted that the encapsulation can be made by the use of a different method. Additionally, after the step f) a step f' of package polishing may be performed.

In the next step, step g, the individual clip is immersed. In another example, the matrix clips are electroplated in this step.

In the next step, step h, the semiconductor device is trimmed and formed such that the at least one external first lead frame terminal 1a, the at least one external second lead frame terminal 2a, the first surface of the first die paddle 1b contact area and the first surface of the second die paddle 2b contact area, the external common clip gate terminal 4a and the at least one external source clip terminal 3a are exposed. In another example, an external source clip flat terminal 3b is exposed as well.

In the next step, step i, the semiconductor device is singulated.

### LIST OF REFERENCE NUMERALS USED

- 1: first lead frame
- 1a: external first lead frame terminal
- 1b: first die paddle
- 1': first surface of the first lead frame
- 1": second surface of the first lead frame
- 2: second lead frame
- 2a: external second lead frame terminal
- 2b: second die paddle
- 2': first surface of the second lead frame
- 2": second surface of the second lead frame
- 3: common clip
- 3a: external source clip terminal
- 3b: external source clip flat terminal
- 3c: first source contact
- 3d: second source contact
- 3': first source surface
- 3": second source surface
- 4: common gate clip
- 4a: external common clip gate terminal
- 4b: clip contact
- 4c: gate clip contact
- 4': first gate surface
- 4": second gate surface
- 5: first semiconductor die
- 5a: first die gate terminal
- 5b: first die source terminal
- 5': first surface of the first semiconductor die (drain of the first die)
- 5": second surface of the first semiconductor die (source of the first die)
- 6: second semiconductor die
- 6b: second die source terminal
- 6': first surface of the second semiconductor die (drain of the second die)
- 6": second surface of the second semiconductor die (source of the second die)
- 7: encapsulation

## Claims

1. A semiconductor device comprising:
a first lead frame with a first surface of the first lead frame and a second surface, wherein the first surface of the first lead frame is directly opposite to the second surface of the first lead frame, comprising at least one external first lead frame terminal and an first die paddle,
a second lead frame with a first surface of the second lead frame and a second surface, wherein the first surface of the second lead frame is directly opposite to the second surface of the second lead frame, comprising at least one external second lead frame terminal and an second die paddle,
a common clip with a first surface and a second surface, wherein the first surface is directly opposite to the second surface, comprising at least one external source clip terminal, a first source contact and a second source contact,
a common gate clip with a first surface and a second surface, wherein the first surface is directly opposite to the second surface, comprising an external common clip gate terminal, a clip contact and a gate clip contact,
a first semiconductor die with a first surface of the first semiconductor die and a second surface, wherein the first surface of the first semiconductor die is directly opposite to the second surface of the first semiconductor die, comprising a first die gate terminal, a first die source terminal, and a first die drain terminal, wherein the first die gate terminal, and the first die source terminal are located on the second surface of the first semiconductor die, and the first die drain terminal is located on the first surface of the first semiconductor die,
a second semiconductor die with a first surface of the second semiconductor die and a second surface, wherein the first surface of the second semiconductor die is directly opposite to the second surface of the second semiconductor die, comprising a second die gate terminal, a second die source terminal, and a second die drain terminal, wherein the second die gate terminal, and the second die source terminal are located on the second surface of the second semiconductor die, and the second die drain terminal is located on the first surface of the second semiconductor die,
wherein the first die gate terminal is connected by connecting means with the first surface of the clip contact, and the second die gate terminal is connected by connecting means with the first surface of the gate clip contact,
wherein the first die source terminal is connected by connecting means with the first surface of the first source contact, and the second die source terminal is connected by connecting means with the first surface of the second source contact,
wherein the first drain terminal is connected by connecting means with the second surface of the first die paddle contact area, and the second drain terminal is connected by connecting means with the second surface of the second die paddle contact area,
wherein further comprises an encapsulation which encapsulates the first die, the second die, the first lead frame, the second lead frame, the common clip and the common gate clip, such that the at least one external first lead frame terminal, the at least one external second lead frame terminal, the first surface of the first die paddle contact area and the first surface of the second die paddle contact area, the external common clip gate terminal, the at least one external source clip terminal, and preferably an external source clip flat terminal of the common clip, are exposed.

2. The semiconductor device according to claim 1, wherein the at least one external first lead frame terminal and the at least one external second lead frame terminal are curved, preferably in a gull wing formation, to access other terminals to form a circuit.

3. The semiconductor device according to anyone of claims 1-2, wherein the connecting means are in a form of solder or similar.

4. The semiconductor device according to anyone of claims 1-3, wherein the connecting means are in a form of connective adhesive.

5. The semiconductor device according to anyone of claims 1-4, wherein the clip contact and the gate clip contact are the most protruding parts toward the first surface in the common gate clip.

6. The semiconductor device according to anyone of claims 1-5, wherein the first source contact and the second source contact are the most protruding parts toward the first surface in the common clip.

7. A method of manufacturing a semiconductor device according to claim 1-6, comprising steps of:
a) dispensing connective means on the first die paddle contact area located on a second surface of the first lead frame and on the second die paddle contact area located on a second surface of the second lead frame,
b) placing the first semiconductor die on the first lead frame such that the first surface of the first semiconductor die is in contact with the second surface of the first lead frame, and the second semiconductor die on the second lead frame such that the first surface of the second semiconductor die is in contact with the second surface of the second lead frame,
c) dispensing connective means on the first die gate terminal, the first die source terminal, the second die gate terminal and the second die source terminal,
d) placing the common gate clip and the common clip to the first die and to the second die,
e) connecting by reflowing or baking,
f) encapsulating the first die, the second die, the first lead frame, the second lead frame, the common clip and the common gate clip, with mold compound or any encapsulation,
g) immersing the individual clip or electroplating the assembled semiconductor devices,
h) trimming and forming the semiconductor device such that the at least one external first lead frame terminal, the at least one external second lead frame terminal, the first surface of the first die paddle contact area and the first surface of the second die paddle contact area, the external common clip gate terminal, the at least one external source clip terminal, and preferably an external source clip flat terminal, are exposed,
i) singulating the semiconductor device.

8. The method of manufacturing a semiconductor device according to claim 7, wherein the common gate clip and a common clip mounting clip is individually and/or matrix mounted.

9. The method of manufacturing a semiconductor device according to claim 7 or 8, wherein after step f) there is an additional step f') of package polishing or any similar method in exposing either the first die paddle, the second die paddle, the at least one external source clip terminal, or the external common clip gate terminal.

10. A method of manufacturing a semiconductor device according to anyone of claims 7-9, wherein the connective means used in steps a) and b) are in a form of conductive adhesive or a solder.
